# EUROPEAN PATENT APPLICATION

(11) **EP 1 026 732 A1**
(43) Date of publication of application: **09.08.2000**
(21) Application number: 99400264.0
(22) Date of filing: 05.02.1999
(51) Int. Cl.: H01L 21/312, H01L 29/06, H01L 23/29

(54) **A method of forming a high voltage semiconductor device**

(71) Applicant: MOTOROLA, INC., Schaumburg, IL 60196 (US)
(72) Inventor: Jaume, Denis, 31770 Colomiers (FR); Martinez, Christian, 31520 Ramonville (FR); Roche, Hervé, 31300 Toulouse (FR); Viale, Eric, 31200 Toulouse (FR)
(74) Representative: Hudson, Peter David

(57) **Abstract**

A method of forming a high voltage semiconductor device comprises the steps of providing a semiconductor substrate (4), forming an active semiconductor region (6, 8, 10) in the semiconductor substrate (4), forming a contact (16) to the active semiconductor region, forming a passivation layer (18) over the contact (16) and the semiconductor substrate (4), the forming a passivation layer step comprising the steps of forming a dielectric layer (20) over the contact (16) and semiconductor substrate (4) and forming a polyimide layer (22) over the dielectric layer (20), and forming a contact opening (24) in the polyimide layer (22) and the dielectric layer (20) which extends through the polyimide layer (22) and the dielectric layer (20) to the contact (16).

## Description

### Field of the Invention

This invention relates to a method of forming a high voltage semiconductor device and a high voltage semiconductor device.

### Background of the Invention

When developing semiconductor devices different requirements which depend on the device application have to be taken into consideration. For power semiconductor devices, this includes problems such as arcing between device contacts, breakdown voltage capability and reliability issues (e.g. due to arcing, device breakdown, and moisture-related failures).

Some methods have been developed in response to these arcing/breakdown/reliability problems.

US patent no. 5,107,323 discloses a passivation layer for providing protection against arcing and charge buildup for semiconductor devices which comprises a semi-insulating nitride layer formed over metal contacts to protect the device from charge buildup and a silicon oxynitride layer formed over the nitride layer to prevent arcing. This arrangement is designed for devices operating at low voltages (devices operating around 30 volts). For such an arrangement, it is not possible to operate at high voltages (greater than 1000 volts) due to device breakdown issues and arcing issues. US patent no. 4,901,133 discloses a multi-layer semi-insulating film for hermetic wafer passivation having sequential layers of undoped amorphous silicon, oxygen doped polycrystalline silicon, silicon rich oxynitride and silicon nitride and overlaid with an organic polyimide layer. Such a passivation structure may provide protection from arcing, but due to the complex process steps required, such a structure is too expensive to implement in a high volume semiconductor device manufacturing process.

European patent application no. EP-A-0408868 discloses a semiconductor device which is capable of sustaining voltages up to 800-900 volts by using a resistive field plate in conjunction with a polycrystalline silicon plate comprising two layers. However, such a technique cannot achieve breakdown voltages of greater than 1000 volts since it does not address the arcing problem and so cannot be used for high voltage applications. Furthermore, the polycrystalline silicon plate is porous and so such an arrangement suffers from reliability problems.

For such high voltage applications (greater than 1000 volts), the breakdown voltage capability of a planar device is typically increased by using guard rings (i.e. auxiliary electrodes). The use of guard rings in semiconductor devices is well known in the art. In a NPN power transistor, for example, a P+ guard ring is produced during a P+ diffusion step and is positioned so that there is a well defined space between it and the collector electrode of the NPN transistor. The guard ring decreases the electric field at the collector-base junction and thereby increases the voltage capability of the device. Although increasing the voltage capability of a device, the guard ring method cannot provide a solution to the arcing problem and may also suffer from reliability problems due to moisture.

For devices which are required to operate at high voltages (i.e. voltages greater than 1000 volts), the arcing problem is usually overcome by using a large die area so as to increase the distance between contacts. Since this increases the size of the device, this solution has a significant disadvantage when the trend is towards producing smaller and smaller devices.

There is therefore a need to provide an improved high voltage semiconductor device and an improved process for fabricating such a device wherein the above disadvantages are obviated.

### Summary of the Invention

In accordance with a first aspect of the present invention there is provided a method of forming a high voltage semiconductor device as recited in claim 1 of the accompanying claims.

In accordance with a second aspect of the present invention there is provided a high voltage semiconductor device as recited in claim 11 of the accompanying claims.

### Brief Description of the Drawings

A preferred embodiment of the present invention will now be described with reference to the accompanying drawings in which:
FIG. 1 is a schematic cross-sectional diagram of part of a high voltage semiconductor device in accordance with the present invention; and
FIGs. 2-7 are schematic cross-sectional diagrams of the high voltage semiconductor device of FIG. 1 during different stages of fabrication.

### Detailed Description of the Drawings

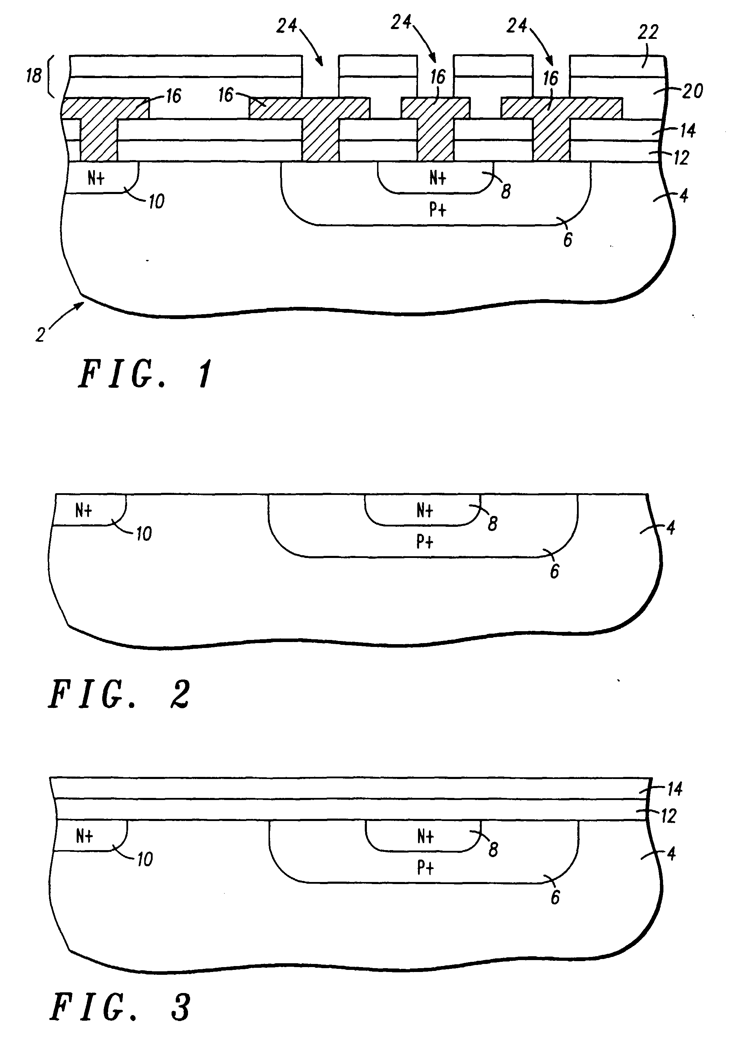

FIG. 1 shows a portion 2 of a high voltage semiconductor device in accordance with the present invention comprising a semiconductor substrate 4. an active region 6, 8, 10 formed in the semiconductor substrate 4 and a layer of semiconductor material 14 formed over the substrate 4 such that the layer extends over at least a portion of the active semiconductor region 6, 8, 10. Contacts 16 are formed so as to be in contact with the active semiconductor region 6, 8 and 10. A passivation layer 18 is formed over the contacts 16 and semiconductor material 12, 14. The passivation layer 18 comprises a polyimide layer 22 formed over a dielectric layer 20. Contact openings 24 extend through the polyimide layer 22 and dielectric layer 20 to the contacts 16.

The dielectric layer 20 is formed of a material, such as a nitride or an oxide, which provides a barrier to moisture, and other contaminants, such as sodium, that will otherwise affect the reliability of the device. In a preferred embodiment, the dielectric layer has a thickness of between 0.4 to 0.8 micrometers.

The polyimide layer 22 provides arcing protection at high voltages and is preferably formed by a curing process that has been optimised to ensure optimum device reliability. Preferably, the polyimide layer has a thickness of greater than 3 micrometers to provide arcing protection and stress at high voltages.

Since the passivation layer 18 in accordance with the present invention is formed over the contacts 16, the passivation layer provides good protection against scratching and also ensures that the high voltage capability techniques which ensure that the device has a high breakdown voltage, such as the resistive field plate method described in European patent application no. EP-A-0408868 or the guard ring method, are not compromised by having additional layers between the contacts and the guard rings or the polycrystalline silicon plate in the case of the method of EP-A-0408868.

In the preferred embodiment described herein, the high voltage semiconductor device comprises a NPN transistor device. The active semiconductor region 6, 8, 10, therefore comprises a base region 6, an emitter region 8 and an isolation region 10. The collector region is not shown in the drawings. The invention however is not limited for use in NPN transistor devices and can be used in any high voltage semiconductor devices, such as NPN bipolar devices, MOS devices, IGBT devices, diodes and rectifiers and can be used for vertical devices as well as planar/lateral devices.

The preferred embodiment described herein shows a high voltage semiconductor device which uses the polycrystalline silicon plate method described in the above referenced European patent application to improve the voltage capability of the device. In the preferred embodiment, the layer of semiconductor material 14 therefore comprises one or two layers of semi-insulating material such as polycrystalline silicon. The polycrystalline silicon layer(s) 14 is formed over an oxide layer 12, such as a layer of thermally grown silicon oxide.

It will however be appreciated that other methods, like the guard ring method, may also be used. In the case of the guard ring method, the layer of semiconductor material 14 will typically comprise a layer of insulating material such as TetraEthyle OrthoSilicate (TEOS) formed over an oxide layer 12, such as a layer of thermally grown silicon oxide. The guard rings will be formed in the semiconductor substrate 4.

A method of forming the high voltage semiconductor device in accordance with the preferred embodiment of the present invention will now be described with reference to FIGs. 1-7. Only brief details will be given as to how the active semiconductor regions, the layer of semiconductor material (i.e. the polycrystalline silicon plate) etc. are formed since, as described above, other techniques may be used.

In the following description, reference is made to layers and regions being formed of specific materials and materials having certain conductivity types, but this is for illustrative purposes only. It is not intended that the present invention be limited to the specific materials referred to herein.

In FIG. 2, a doped region 6 of P+ conductivity type is formed in a semiconductor substrate 4, which may comprise n-type silicon. Once doped region 6, which acts as the base region of the NPN device, has been formed, doped regions 10 and 8 are formed in the semiconductor substrate 4 and the base region 6 respectively by diffusion with an N+ conductivity type dopant. The N+ doped region 8 forms an emitter region of the NPN device and the N+ doped region 10 forms an isolation channel.

Next an oxide layer 12 is formed on the semiconductor substrate 4, as shown in FIG. 3. This oxide layer 12 is conveniently formed from thermally grown silicon oxide. Once the silicon oxide layer 12 has been formed, a polycrystalline silicon layer 14 is formed over the layer 12. The polycrystalline silicon layer 14 may comprise one or more polycrystalline silicon layers having different resistivities. The polycrystalline silicon layer 14 may be formed by LPCVD using the reaction between silane (SIH₄) and oxygen protoxyde (N₂0).

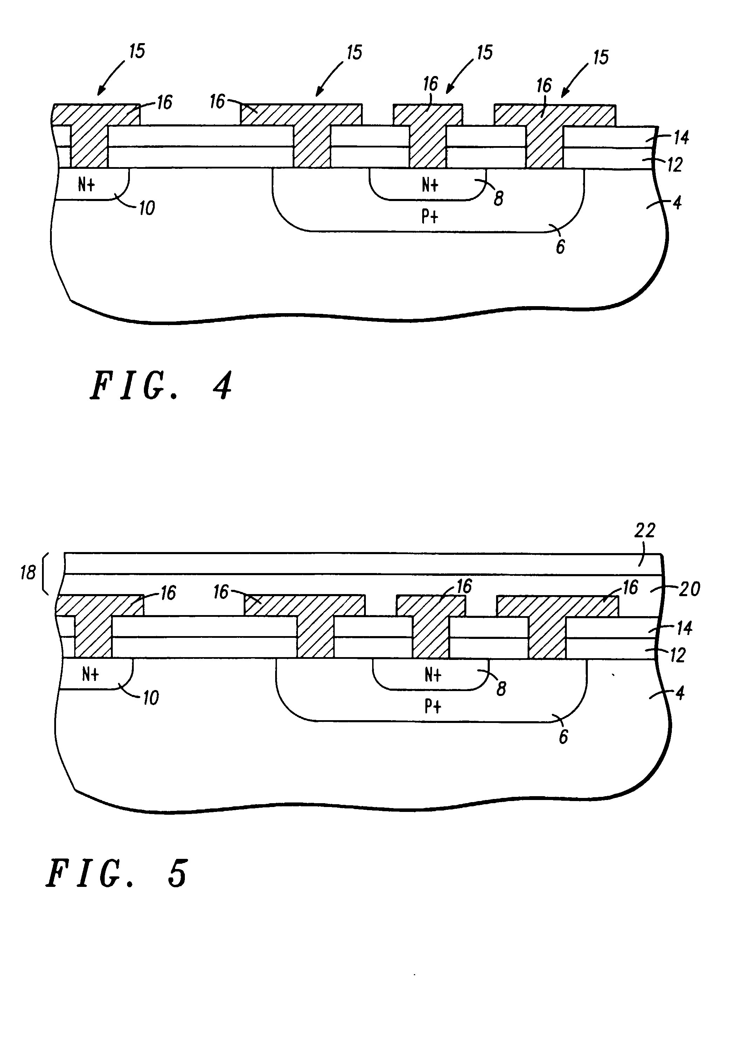

Openings 15 are formed extending through the polycrystalline silicon layer 14 and layer 12 to the semiconductor substrate 4 (see FIG. 4). The openings 15 are disposed on the doped regions 6, 8 and 10. A metallisation layer, such as aluminium, is deposited using vacuum evaporation, deposition or sintering over the polycrystalline silicon layer 14 and in the openings 15. The metallisation layer is then etched to leave contacts 16 in the openings 15 in contact with the doped regions 6, 8 and 10.

Next the passivation layer 18 is formed. A dielectric layer 20, such as silicon nitride, is formed over the polycrystalline layer 14 and contacts 16 by for example LPCVD or PECVD, FIG. 5. The LPCVD or PECVD parameters are selected so as to achieve a nitride dielectric layer 20 having a thickness in the range of 0.4 to 0.8 micrometers. Then, a polymide layer 22 is formed over the dielectric layer 20, for example, by spin coating at a speed and for a time required to yield the desired thickness, which thickness is greater than 3 microns and preferably in the range of 3-5 micrometers.

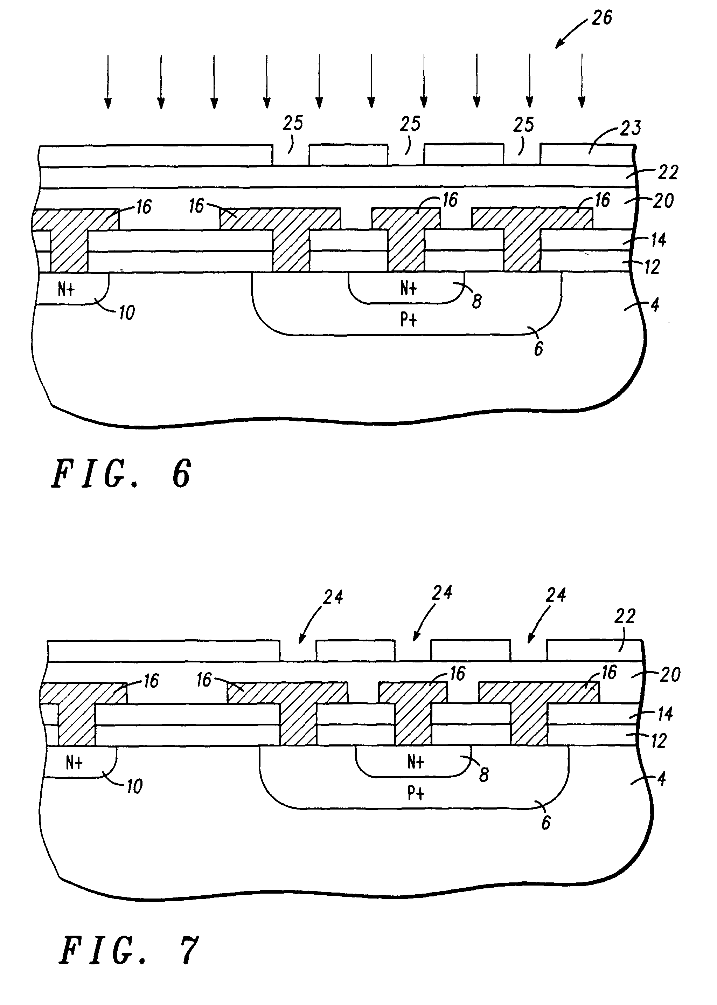

For the passivation photo-step, a passivation mask 23, which may be part of an aligner tool, is used over the polyimide layer 22. The mask 23 is patterned so that it comprises openings 25 as shown in FIG. 6. In the preferred embodiment, a photosensitive polyimide (which can be positive or negative) is used in the spin process to produce a photosensitive polyimide layer 22 so that the polyimide layer 22 can be patterned using photolithography techniques. Other patterning techniques may also be used, for example when a non-photosensitive polyimide resin is used.

The partially processed device is exposed to radiation 26, such as UV radiation, to transfer the pattern of the mask 23 to the polyimide layer 22. After the photo-step, the polyimide layer 22 is developed, for example using a polyimide developer such as a mixture of 50% xylene and 50% NMP (N Methyl-Propylene), so as to remove the portions of the polyimide layer 22 which were exposed to the UV radiation (for a positive photosensitive polyimide) to leave contact openings 24 extending through the polyimide layer 22 to the dielectric layer 20 (FIG. 7). For a negative photosensitive layer, the mask will be arranged such that the portions of the nolvimide layer over the contacts are not exposed to radiation so that these portions are removed on developing the polyimide layer.

The polyimide layer 22 is then cured by placing the partially processed device in a furnace at a temperature of about 350 °C for a few hours in the presence of nitrogen gas N₂. For each type of device, the optimum curing process parameters, such as curing temperature, and curing time, which provide optimum reliability in the device are determined. Since the colour of the polyimide layer changes on curing, when curing occurs at the optimum curing process parameters, the polyimide layer will have a distinguishable colour. Thus, the fact that the colour of the polyimide layer changes according to the curing process can be used to detect those devices that have greater reliability over those that don't. In other words, those devices which after processing have a polyimide layer whose colour is substantially not the same as che distinguishable colour may be recognised as unreliable or failed devices and rejected.

After the polyimide layer has been cured, the dielectric layer 20 is dry etched using the polyimide layer 22 as a 'master mask' to extend the contact openings 24 through the dielectric layer 20 to the contacts 16. In this etching step, some (less than 1 micron) of the polyimide layer 22 will also be etched. The fact that the polyimide layer 22 acts as a 'master mask' to etch the dielectric layer ensures that the contact openings in the dielectric layer and polyimide layer 22 are self-aligned.

Since only one mask 23 is used to form the contact openings in the double passivation layer 18, the preferred embodiment of the present invention provides a one mask step double passivation layer which greatly simplifies the manufacturing process and ensures self-alignment between the double layers.

An advantage of using a photosensitive polyimide layer 22 is that only a single etch operation (i.e. to etch the nitride) is required to form the contact openings in the passivation layer 18.

The polyimide layer 22 provides arcing protection and the dielectric layer 20 and the optimised curing process ensures good device reliability.

In summary, the present invention provides a high voltage semiconductor device having a double layer passivation which prevents arcing between the device contacts at high voltages (greater than 1000 volts) without the need to increase the die size and which improves the reliability of the device. The passivation layer in accordance with the present invention can be fabricated without the need for complex process steps and in the preferred embodiment with only one passivation mask.

Since a dielectric layer is formed over the contacts, the present invention also ensures there are no reliability problems due to poor adhesion between the contacts and passivation layer.

Furthermore, the benefits of having an optimised structure for breakdown voltage can be maintained as the dielectric layer 20 is formed over the contacts and does not interact with the layers 12 and 14.

## Claims

1. A method of forming a high voltage semiconductor device comprising the steps of:
providing a semiconductor substrate (4);
forming an active semiconductor region (6, 8, 10) in the semiconductor substrate (4) ;
forming a layer of semiconductor material (12, 14) over the semiconductor substrate (4) such that the layer extends over at least a portion of the active semiconductor region (6, 8, 10);
forming a contact (16) to the active semiconductor region (6, 8, 10), the contact (16) extending over a portion of the layer of semiconductor material (12, 14);
forming a passivation layer (18) over the contact (16) and the layer of semiconductor material (12, 14) the forming a passivation layer step comprising the steps of forming a dielectric layer (20) over the contact and layer of semiconductor material and forming a polyimide layer (22 ) over the dielectric layer (20): and
forming a contact opening (24) in the polyimide layer (22) and the dielectric layer (20). the contact opening (24) extending through the polyimide layer (22) and the dielectric layer (20) to the contact (16).

2. The method of claim 1 wherein the forming a contact opening step comprises the steps of:
patterning the polyimide layer (22) and then removing a patterned portion of the polyimide layer (22) so as to provide a contact opening (24) in the polyimide layer (22) that extends to the dielectric layer (20); and
removing a portion of the dielectric layer (20) through the contact opening (24) in the polyimide layer (22) so as to extend the contact opening (24) through the dielectric layer (20) to the contact (16).

3. The method according to claim 2 wherein the polyimide layer (22) comprises a photosensitive polyimide material, and wherein the patterning step comprises:
providing a mask layer (23) over the polyimide layer (22), the mask layer (23) having an opening such that a portion of the polyimide layer (22) is exposed; and
exposing the exposed portion of the polyimide layer (22) to radiation to provide a patterned portion of the polyimide layer (22).

4. The method of any preceding claim further comprising, after the forming a passivation layer step, the step of curing the polyimide layer (22).

5. The method of claim 4 further comprising the steps of:
determining optimum curing process parameters for the polyimide layer (22);
identifying the colour of the polyimide layer (22) after carrying out the step of curing using the determined optimum curing process parameters; and
rejecting, after the curing step, those devices having a polyimide layer (22) whose colour is substantially not the same as the identified colour.

6. The method of any preceding claim wherein the polyimide layer (22) has a thickness greater than 3 micrometers.

7. The method of any preceding claim wherein the polyimide layer (22) has a thickness in the range of 3-5 micrometers.

8. The method of any preceding claim wherein the dielectric layer (20) is one of the following: a nitride layer and an oxide layer.

9. The method of any preceding claim wherein the step of forming a layer of semiconductor material (12, 14) comprises the step of forming one or two layers of semi-insulating material over the semiconductor substrate (4).

10. The method of any one of claims 1 to 8 wherein the step of forming a layer of semiconductor material (12, 14) comprises the step of forming a layer of insulating material over the semiconductor substrate (4).

11. A high voltage semiconductor device comprising:
a semiconductor substrate (4);
an active semiconductor region (6, 8, 10) formed in the semiconductor substrate (4);
a layer of semiconductor material (12, 14) formed over the semiconductor substrate (4) such that the layer extends over at least a portion of the active semiconductor region (6, 8, 10);
a contact (16) in contact with the active semiconductor region (6, 8, 10), the contact (16) extending over a portion of the layer of semiconductor material (12 14);
a passivation layer (18) formed over the contact (16) and the layer of semiconductor material (12, 14), the passivation layer (18) comprising a dielectric layer (20) over the contact and layer of semiconductor material and a polyimide layer (22) over the dielectric layer (20); and
a contact opening (24) in the polyimide layer (22) and the dielectric layer (20), the contact opening (24) extending through the polyimide layer (22) and the dielectric layer (20) to the contact (16).

12. The high voltage semiconductor device according to claim 11 wherein the polyimide layer (22) has a thickness of greater than 3 micrometers.

13. The high voltage semiconductor device according to claim 11 wherein the polyimide layer (22) has a thickness in the range of 3-5 micrometers.

14. The high voltage semiconductor device according to claim 11, 12 or 13 wherein the dielectric layer (20) is one of the following: a nitride layer and an oxide layer.

15. The high voltage semiconductor device according to claim 11, 12, 13 or 14 wherein the layer of semiconductor material (12, 14) comprises one or two layers of semi-insulating material.

16. The high voltage semiconductor device according to claim 11, 12, 13 or 14 wherein the layer of semiconductor material (12, 14) comprises a layer of insulating material.

17. A method of forming a high voltage semiconductor device comprising the steps of:
providing a semiconductor substrate (4)
forming an active semiconductor region (6, 8, 10) in the semiconductor substrate (4);
forming a contact (16) to the active semiconductor region (6, 8, 10);
forming a passivation layer (18) over the contact (16) and the semiconductor substrate (4). the forming a passivation layer step comprising the steps of forming a dielectric layer (20) over the contact (16) and the semiconductor substrate (4) and forming a polyimide layer (22) over the dielectric layer (20); and
forming a contact opening (24) in the polyimide layer (22) and the dielectric layer (20), the contact opening (24) extending through the polyimide layer (22) and the dielectric layer (20) to the contact.
